# EUROPEAN PATENT APPLICATION

(11) **EP 1 351 462 A1**
(43) Date of publication of application: **08.10.2003**
(21) Application number: 03006654.2
(22) Date of filing: 25.03.2003
(51) Int. Cl.: H04L 25/49

(54) **Error Correcting 8B/10B Transmission System**

(30) Priority: 29.03.2002 US 368578 P
(71) Applicant: MystiCom, Ltd., Netanya 42504 (IL)
(72) Inventor: Lida, Eyran, 71700 Modi'in (IL); Shahar, Boaz, 43602 Ra'anana (IL); Greiss, Israel, 43602 Ra'anana (IL)
(74) Representative: Manitz, Finsterwald & Partner GbR

(57) **Abstract**

By applying additional error correction during transmission of any 8B/10B pattern without increasing the number of overhead bits, improved performance is possible, while still maintaining the other advantages of the 8B/10B code. In effect, a new "coding layer" is added wherein the 8B/10B encoded data goes through a low latency encoding process during transmission, and is regenerated by a complementary low latency decoding process during the receive process, to provide a coding gain of the code of about 5-6 dB (from about BER=1e-5 to about BER=1 e-17) by detecting and correcting errors during transmission in the communication channel. Moreover, it is now possible to have an additional communication channel between both end stations with a side-band channel data rate of about 16mbps. The original 8B/10B data stream data rate remains the same and the user gets the benefits of the error correction and additional communication channel without any bandwidth penalty.

## Description

### FIELD OF THE INVENTION

The present invention relates generally to the transmission of digital information over a transmission link, and more particularly to an encoder/decoder that provides improved error correction to 8B/10B encoded blocks.

### BACKGROUND

An 8B/10B coding scheme is the basis for several high speed serial communication protocols and standards, including **1000BASE-X, Fiber Channel, InfiniBand, 10GBASE-X, 10GFC, XAUI**. In addition, related codes are used in many proprietary implementation of backplane transceiver devices. 8B/10B coding has become a popular method used by many serial communication protocols and standards, employing embedded clock and control information, such as are found in SERDES devices for communication applications, PHY layer devices for communication, back plane transceivers in Internet switches and routers, chip to chip communication over a low pin count high-speed interface, crossbar switches for Internet packets, multi-SERDES modules, and various low latency optical communications systems.

An 8B/10B code scheme adds overhead of 25% to the data by converting each 8-bit data "byte" to a 10-bit "code-word" (sometimes called a "symbol"). By using a "code-group" in which the same "transmission data character") may be represent by different code-words with different numbers of 1s and 0s, it is possible to maintain a low local "disparity" (and thus a low DC balance, in the case of bipolar electrical transmission) in the transmission stream by choosing a code word from the code-group that reduces the disparity. Moreover, because there are more distinct possible code-groups than distinct possible data bytes, 8B/10B coding potentially provides the following features:
- sufficient signal transitions for facilitating simple and accurate bit clock recovery at the receiver by avoiding code-words that lack sufficient high frequency content. In the case of a well-established 8B/10B protocol, the permissible 10-bit transmission characters consist only of code words having at least four 1s and at least four 0s
- protocol dependent "control" code-words that are not part of any data code-group. In the established 8B/10B protocol, there are 12 different such control code-words, in addition to the 256 (2e8) different data code-words.
- a special code group whose members have a distinctive bit pattern that can be used for synchronization and framing because it does not correlate with any other possible transmission character or sequence of characters in the encoded data stream. In the particular case of the established 8B/10B protocol, the distinctive pattern is 5 successive bits of the same polarity and is found only in a "comma" control code-group.

By appropriate design of control protocol, for example, by requiring multiple transmissions of the same control command, and/or confirmation back to the sender, commands transmitted in error can be detected and ignored or corrected. However, in general an 8B/10B code does not have any reliable internal mechanism for correcting errors in the transmitted data. Since not all possible code words are found in the permissible code groups, certain single and multiple bit errors will result in detectable code violations, which can be sometimes be correlated to a legal code word differing from the illegal word by a significantly smaller distance than all other legal code words. However, any resultant improvement in bit error rate of the encoded 8B/10B data is small relative to the uncoded data. Furthermore, at least some of the legal 8B/10B code groups will include one or more code words that are at a distance of only one bit from other legal code words in other code groups, so even if an error is detected, it cannot always be reliably corrected. As a result, the 8B/10B coding scheme is not able to detect all single bit errors in the received data bytes, let alone ensure that all such single bit errors will be corrected

### SUMMARY

By applying additional error correction during transmission of data and control information conforming to 8B/10B standards and protocols, without increasing the number of overhead bits, it is now possible to provide an improved performance that otherwise would not be possible, while still maintaining the other advantages of the 8B/10B code as defined above. Depending on how that improved performance is exploited in a particular system application, some or all of the following are now possible:
- Enhanced transmission distance for the same transmission power.
- Higher data rates for existing back planes
- Enhanced error correction at the receiver without any increase in bandwidth.
- Out-of-band communications
- Seamless interoperation with both coded and unencoded upper layers.
- Low latency, mission critical applications such as' back plane transceivers

In effect, a new "coding layer" is added wherein the 8B/10B encoded data goes through a low latency encoding process during transmission, and is regenerated by a complementary low latency decoding process during the receive process, to provide a coding gain of the code of about 5-6 dB (from about BER=1e-5 to about BER=1e-17) by detecting and correcting errors during transmission in the communication channel. Moreover, it is now possible to have an additional communication channel between both end stations with a side-band channel data rate of about 16mbps.

Theses additional capabilities, i.e. the ability to fix channel errors, and the ability to carry additional channel information, the side band channel, do not result in any channel bandwidth loss. The original 8B/10B data stream data rate remains the same and the user gets the benefits of the error correction and additional communication channel without any bandwidth penalty.

Following is a detailed description of a specific implementation of our new 8B/10B-compatible error-correcting coding scheme, including an encoding algorithm and implementation, a decoding algorithm and implementation, and general architecture elements intended for integration into an operational system within a not-yet announced MystiCom product called Enhanced QuadLane (EQLN). In this particular application, our new coding scheme makes possible an on-chip XAUI high speed serial high speed interface link over a relatively lengthy signal path, and at the same time reduces the XAUI link's sensitivity to signal quality degradation, adverse environmental effects, and AFE impairments.

The XAUI standard as defined by the IEEE uses a native 8B/10B data stream to form an aggregate of 4 lanes. The EQLN system encodes/decodes the data stream on each lane separately without losing the ability to perform the required aggregation above each EQLN sub-layer. Additionally the EQLN system provides a separate synchronous Side Band Information channel that is not required by the XAUI standard and still maintains the same throughput as in standard XAUI. These features enable the use of a standard 8B/10B AFE (Analog Front End) and CDR (clock Data Recovery) implementation as an interface to the media and to "look like" any 8B/10B device from the upper layer point of view.

However, it should be understood that our invention is not limited to the described EQLN implementation, and that other implementations and applications of its underlying concepts involving other standards and other design objectives will doubtless be apparent to those skilled in the art.

### DRAWINGS

Fig. 1 is a overall functional diagram of an exemplary encoding/decoding system for a receiver/transmitter whereby an 8B/10B code is provided with an additional coding layer.

Fig. 2 is a system block diagram for an encoding/decoding subsystem suitable for use with the system of Fig. 1.

Fig. 3 depicts a data structure for a possible application of the additional data correction and the additional communication channel, in which each protected 380 bit block includes four 50-bit groups of 6 elements, and two 58-bit groups of 7 elements.

Fig. 4 depicts a data structure for a 58-bit group of 7 elements.

Fig. 5 depicts a data structure for a 50-bit group of 6 elements.

Fig. 6 depicts how one additional overhead bit may designate which elements of the 58-bit group of Fig. 4 are 8-bit data elements and which are 4-bit control elements.

Fig. 7 is a variation on Fig. 6 applied to the 50-bit group of Fig. 5.

Fig. 8 is a block diagram for an exemplary scrambler circuit for scrambling the groups of Figs. 4 and 5.

Fig. 9 is a block diagram for an exemplary block synchronizer circuit.

Fig. 10 depicts a block synch mismatch.

Fig. 11 is a block diagram for an exemplary decoder circuit for using error location information from an RS decoder to generate a serial stream of scrambled data.

Fig. 12 is a block diagram for an exemplary descrambler circuit for unscrambling the corrected data from Fig. 11.

### DETAILED DESCRIPTION

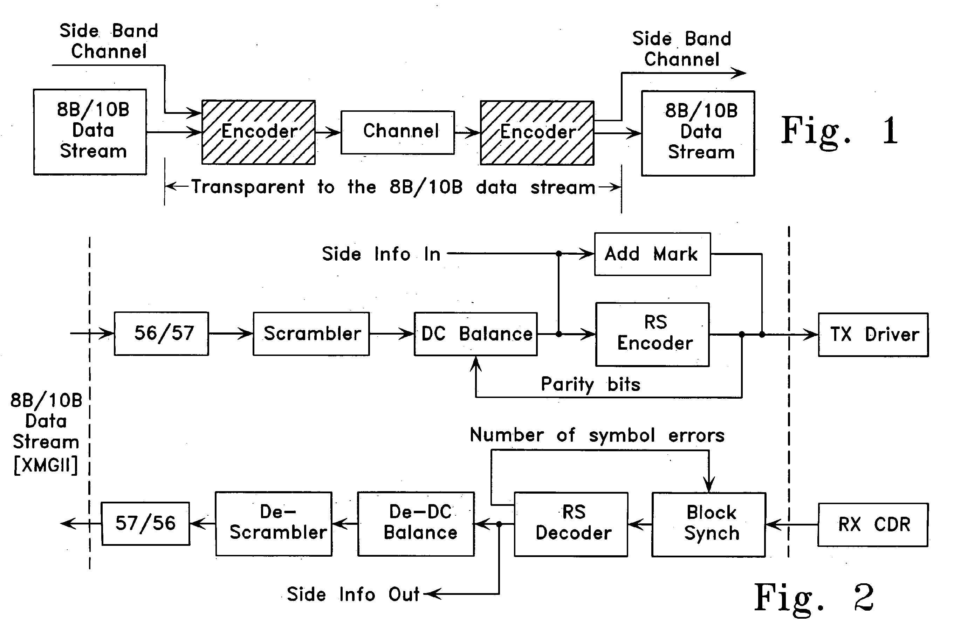

The block diagram of Fig. 1 shows the overall organization of our invention, as implemented in the aforementioned EQLN application. A decoded or not yet encoded **8B/10B data stream** containing a succession of 8-bit data elements and 4-bit control elements (preferably represented in conventional XGMII format) enters our **encoder** together with an optional side band channel which are combined to generate an "encoded bit stream" of serially transmitted 380-bit EQLN blocks. This encoded bit stream is transmitted over **a communication channel** (preferably at the same bit rate as a conventionally encoded 8B/10B stream) to our decoder which separates out the optional **side band** channel and regenerates the original XGMII-formatted **8B/10B data stream.** We use a Reed Solomon ("RS") code, as an error correcting sub-layer, preferably working over GF(2^6) (each RS symbol is 6-bits long) with hard decisions to reduce complexity and with relatively short blocks to reduce latency.

Fig. 2 shows our proposed encoder/decoder subsystem in more detail. In particular, as shown in the upper half of the Figure, which collectively corresponds to our previously mentioned **encoder**, successive groups of 6 or 7 XGMII elements are initially processed by a **56/57** encoder, which adds a single overhead bit to designate which of the elements in the following group are data elements and which are control elements. The group including the 56/57 overhead bit is then processed in a **Scrambler**, a **DC Balance** circuit adds a DC balance overhead bit which specifies whether that group should be inverted to reduce disparity, and the entire resultant 50- or 58-bit group together with optional **Side Info** is assembled into an RS block in an **RS Encoder** which adds **Parity** bits to protect the **Side Info**, the XGMII elements, and the overhead bits attached to each group, prior to transmission via a **TX Driver**.

As shown by the lower half of Fig. 2, a reverse process occurs in our **decoder**. In particular, the data and recovered clock from the received EQLN block is input to a Block Synch block, which in cooperation with symbol error information from an RS decoder, locates a block boundary and thereby establish Block Synch, the **RS Decoder** then corrects any errors located in the protected Side info, the XGMII elements, and the overhead bits. from which the **Side Info** is extracted, a **De-DC Balance** circuit uses the recovered DC Balance bit to restore the state of any previously inverted group, a **De-scrambler** circuit recovers the 56/57 Overhead bit and the previously scrambled group data, and finally a **57/56** decoder uses the recovered 56/57 overhead bit to identify the individual data and control elements in each group.

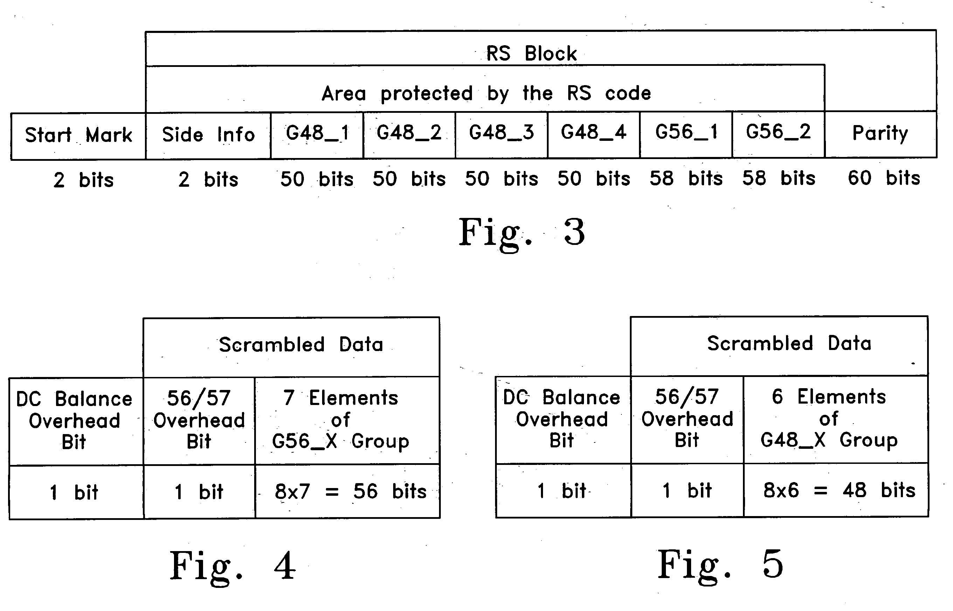

The data structure for a single lane of a typical 380-bit EQLN block is shown in Fig. 3: Each 380-bit EQLN block encodes 38 cycles of XGMII/TBI data which in each cycle (as will be described in more detail hereinafter with respect to Figs. 4, 5, 6 and 7) can deliver for each lane, an 8-bit data word or a 4-bit control word. Each 4-bit control word of our EQLN system can represent one of up to 16 (2e4) distinct control words and can appear anywhere within the data steam.

Returning to Fig. 3, it should be noted that the EQLN Block is transmitted from "left to right" which means that the **Start Marker** field is transmitted first and the **Parity** is transmitted last. This "left to right" transmitting order, convention, is kept in all the figures in this document. As shown, these 38 XGMII/TBI elements (data or control words) are divided into 6 groups: 4 groups (**G48_1 ... G48_4**) with 6 elements in each group (requiring a total of 48 bits if all 6 elements are 8-bit data words), and 2 groups (**G56_1, G56_2**) with 7 elements each (requiring a total of 56 bits if all 7 elements are 8-bit data words.

As shown in Figs.4 and 5, for each **G48 or G56** group, the encoding subsystem adds one **56/57 overhead bit** for distinguishing data and control words and a **DC balance overhead bit** to control DC balance.

### 56/57 Encoder

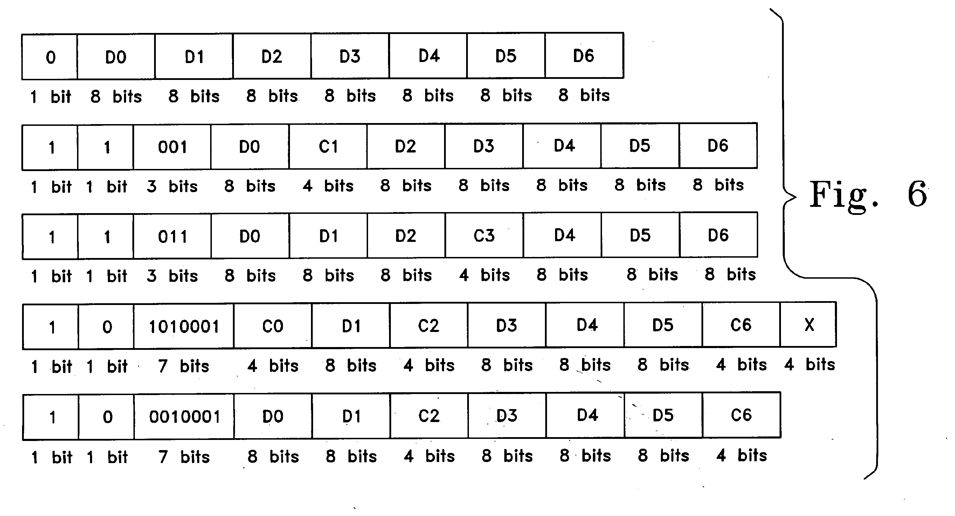

Reference should now be made to Fig. 6, which depicts an encoding method which identifies control elements appearing anywhere within the basic **G56** group of 7 data/control elements (56 bits) with just one bit of overhead and only one cycle of latency inherited by the decoding process. Since each control element is represented by 4 bits, the depicted encoding could support up to 16 types of controls words. Since each data element is represented by 8 bits, for each control element in the group we "earn" additional 4 bits for use in the encoding scheme. The method distinguish between 3 types of groups:

The **56/57 overhead bit** is transmitted before the group elements and marks if this particular **G56** group contains any control elements. If the **56/57 overhead bit** is set to "0" then, there are no control element in the group and group is of type 1.

Otherwise the next bit defines whether the group if of type 2 or type 3. If the next bit is "1" then the group is of type 2, in which there is one and only one control element and the next 3 bits represent this element **index** with in the group (The **MSb** of this 3-bit index is shown on the left and is transmitted first). Each **G56** group has 7 elements starting at index 0 (for example, data element **D0**) and ending with index 6 (for example, control element C**6**).

If the group is of type 3 then the next 7 bits form a seven bit **mask** corresponding to the 7 following group elements: If the first bit of the 7-bit mask is a "1" then the first group element (index 0) is a control element, if the first bit is "0" then the first group element is a data element. Similarly, if the second bit is "1" then the second group element is control and if it is "0" then the second group element is data element and so on for all the 7 elements.

Group elements are transmitted back to back while their size is dependent on their type (each data element is 8 bits and each control element is 4 bits). For groups of type 3 with more than 2 control elements, each additional control element contributes 4 unused bits to that group. Any such unused bits are transmitted at the end of the group to keep the group size fixed on 57 bits and are available for optional use as an additional asynchronous channel between the transmit and receive devices. Note that during XAUI Idle periods most of the elements will be control elements and the capacity of this asynchronous extra channel will increase. Thus, if all the elements are control elements then the instantaneous rate of this extra channel will be 104/380*BaudRate, which in the particular case of XAUI, equates to 855MHz.

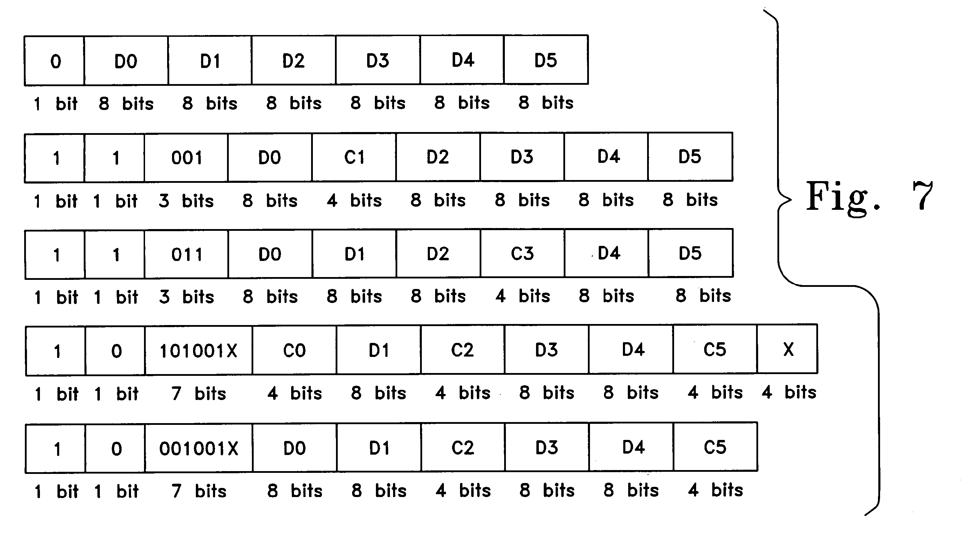

In the EQLN block depicted in Fig. 3, there are four **G48** groups which contain only 6 elements instead of 7. In this case a similar **56/57 encoding** is as in Fig. 6 without the 7^{th} element to produce 49 bits from 48 bits (48/49). The resultant encodings are depicted in Fig. 7.

### Scrambler

As shown in detail in Figs. 4 and 5, most of the EQLN block data is scrambled but the **DC balance control** bits (together with the **parity** bits, the **side info**, and the **start mark** of Fig. 3) are not scrambled. Such a scrambler provides an improved spectrum (a white-like spectrum facilitates adaptive channel equalization mechanisms.) and a high transition density of the transmitted data, but at no associated cost (as measured by additional bits of overhead).

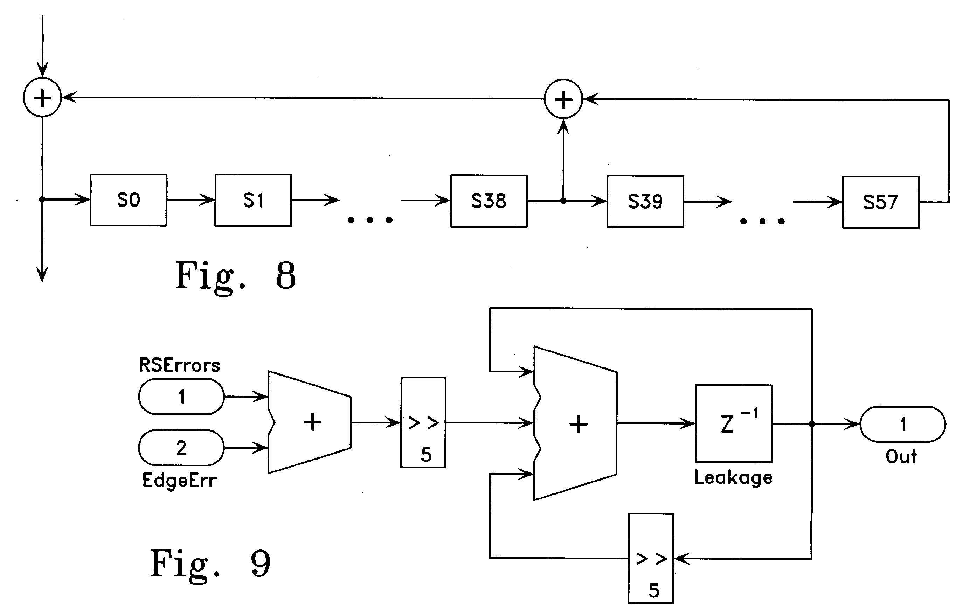

The **scrambler** is preferably a self synchronized scrambler with the following polynomial: G(x) = 1+x^39+x^58. This is the same type of scrambler that is used in IEEE 10GBASE-R draft 802.3ae, and is depicted graphically in Fig. 8. A self synchronized scrambler simplifies the synchronization between the TX side and the RX side by eliminating the need to pass the scrambler seed from side to side in special frames. However, in order to improve latency without excessive complexity, in the proposed EQLN system, the **scrambler** will preferably be implemented as a 3 option, parallel device which scrambles 24, 25 or 32 bits in parallel, which permits scrambling each group as two subgroups in succession (a G58 group has 57 = 25+32 scrambled bits and a G50 group has 49 = 24+25 scrambled bits) in only two system cycles .

### DC Balance Control

As shown in Fig. 2, a **DC balance** control circuit adds a **DC Balance bit** to the output of Scrambler in order to improve the DC balance at each group boundary. There is a global counter which continually counts the running disparity of the transmitted data (all the data including RS **parity** bits which are not protected by this DC balance control). For each group the EQLN calculates its group disparity and compare with the global disparity status. If the group disparity has the same sign as the global disparity then the group bits are flipped and the **DC balance control bit**, which we add at the beginning of the group, will be set to 1. Else it will be set to 0 and the group bits are transmitted unchanged.

The 60 **parity** bits which the **RS encoder** adds at the end of the EQLN block are preferably neither scrambled nor inverted by any DC balance mechanism . Otherwise, the "DC Balance Overhead Bits" would not be protected by the RS code and any wrong re-inversion would cause many undetectible errors. Similarly, if the parity bits were scrambled, then they would have to be de scrambled prior to decoding with a much higher probability of amplifying any pre code errors by an incorrect de-scrambling. In any event, the maximum disparity is bounded by the maximum possible disparity of the last group plus that of the parity (i.e., the combined size of both fields, or a total of about 120 bits), and as shown in Fig. 2, any resultant disparity increase attributable to the parity bits will be part of the running disparity count used to determine whether subsequent protected Groups will be inverted and the disparity count thereby reduced.

### Reed Solomon Encoder

The **RS encoder** uses a GF(2^6) code, which means that each RS symbol has a size of 6 bits. As shown in Fig. 3, the proposed EQLN implementation uses an RS block having a total of 63 RS symbols (378 bits) where 10 symbols (60 bits) are the **parity** bits which the encoder appends to the end of the RS block to enable correction of up to 5 symbol errors in each RS block. The remaining 53 RS symbols (318 bits) are the **RS block data** which are 38 bytes of XGMII data (304 bits, or a same number of 56/57 encoded mixed data and control bits) + 6 bits of **56/57 overhead** + 6 bits of **DC balance control** + 2 bits of **side info.** This non standard RS encoding scheme provides a low latency with significant coding gain (improved ability to function in a noisy environment) and with less overhead than conventional 8B/10B coding. In particular, GF(2^6) RS encoding permits a relatively simple decoder, and a 63 symbol block is the most efficient block size for GF(2^6). The encoder does not change the block data it just appends the parity bits at the end. For some applications, it may be preferable to implement a parallel implementation of the **RS decoder**, in order to reduce the latency of the system. More detailed information of suitable conventional RS encoders can be found in the literature.

EQLN is designed to operate at a native rate of 10bits transmitted each cycle, inherited from the XAUI AFE system and the conventional 8B/10B coding on which it is based. The proposed GF(2^6) **RS encoder** functions at a native rate of 1 symbol of 6 bits in a single cycle. To provide a simple mechanism for coordinating these rates, the **RS encoder** preferably has the ability to deal with an input consisting of either 1 or 2 RS symbols (6 or 12 bits) in each cycle . Although in some applications a conventional serial implementation of the **RS encoder** will be preferable for reasons of cost and/or ease of implementation, we plan to use a parallel implementation of the **RS encoder** in EQLN in order to further reduce the latency.

### Synchronization at the Receiver

Reference should now be made to Figs. 2 and 9 The first task for the EQLN receiver is to synchronize on the EQLN block boundaries. The first two bits in each block are not protected by the RS code and they are called "**start mark**" bits. The next two bits are the **side info** bits which are protected by the RS code. The value of the **start mark** bits is the opposite of the **side info** bits what ever they are. In this way DC balance among these 4 bits is guaranteed and also at least one transition.

The **block synch** block (Fig. 2) finds locations within the incoming bit stream which match the possible start of block criteria and starts feeding the **RS decoder** with data. The **RS decoder** assumes this is a valid RS block and outputs the number of pre-code symbol errors **RSErrors** in this RS block together with an indication **EdgeErr** as to whether these errors occur at the edge (first symbol or last symbol) of the RS block.

As shown in Fig., 9, the **block synch** block take this feedback from the **RS decoder** and perform **leakage** integration on these results. The output **out** of this leakage integrator reflects the errors density in a 32 (2^5) window of the RS blocks. If the error density is higher than certain threshold then we are not in synch or there are too many pre code errors and the **RS decoder** cannot work in these conditions.

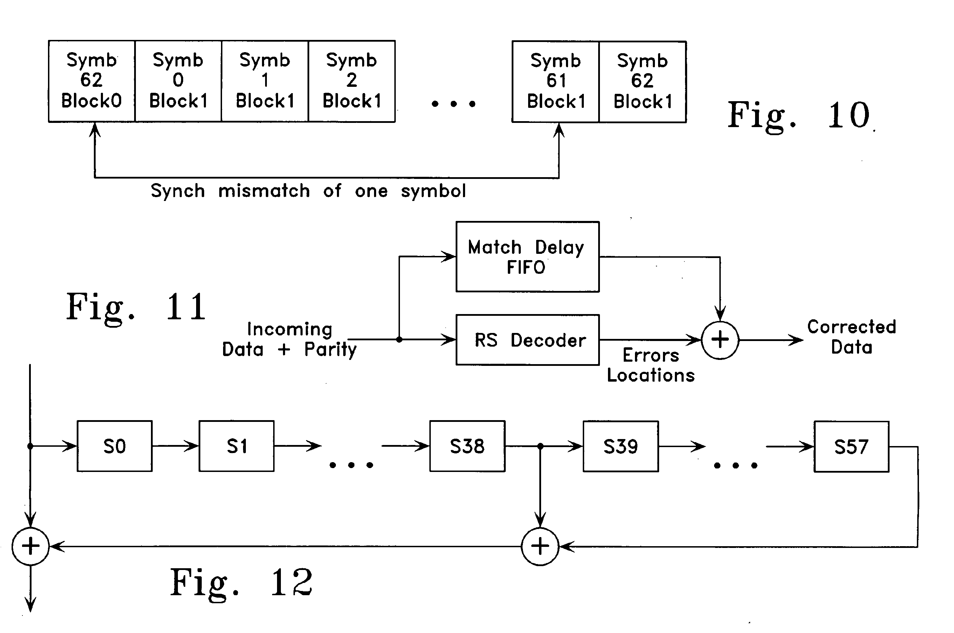

As shown in Fig. 10, if we are not in synch the **RS decoder** will typically detect many errors in the "RS Blocks" it sees, but if we have an **offset** of one symbol from the real synch location then the **RS decoder** will detect only one error in each frame. This is due to the fact the RS code is a cyclic code and if we have move one symbol from the real synch location then we have 63/64 probability to see 1 error and 1/64 probability to see no error.

In 63 out of 64 cases a synch mismatch of one, two, three... symbols will cause an **edge error** at the edge of the RS block. By adding this indication to the **leakage** integrator we increase the error density caused by synch mismatch and we can differentiate between this kind of error and a situation where we are in synch with a lot of errors. In the case of synch mismatch we will see edge error only if all the 63 symbols are correct ((1-P)^63) but we are not in synch, shifted in 1,2,3... symbols (this is of course only part of cases in which we will see edge errors while synch is shifted), and, assuming pseudo random data (which the scrambler is taking care of ), in 63 out of 64 cases we will see edge error. For example if P equal to 1e-3, which is a very high probability for this kind of system, then: P*2/64 = 3.125e-5 and (1-P)^63*63/64 = 0.92 For smaller P the difference will be larger.

### Reed Solomon Decoder

Like the encoder, the **RS decoder** (see also Fig. 11) preferably has the ability to handle one or 2 symbols as an input in each cycle. Within each RS block of **Incoming Data + Parity**, the **RS decoder** generates an output with marked **errors locations**, which is then bitwise combined with a delayed copy of the incoming **Data** (stripped of the **Parity** bits) from **Match Delay FIFO** to provide a **Corrected Data** output in which each erroneous bit has changed its state.

A more detailed description of a suitable **RS decoder** can be found in the literature. We can use either a conventional **RS decoder** or a parallel implementation with reduced latency.

### De DC Balance

The corrected data passed from the RS decoder to the **De-DC balance** where each **DC balance** control bit is examined and if active the bits of the following group are flipped. There is no need to wait for all the group elements because the DC control bit is at the group start and the individual group elements are flipped as they arrive, thereby reducing latency at the receiver.

### De Scrambler

The self synchronized **de scrambler** is shown conceptually in Fig. **1**. Similar to the **scrambler** of Fig. 8, descrambling is preferably done in parallel to minimize latency.

The **Serial Scrambled Input Data** bits fed into the **de scrambler** have low error probability due to the fact that they are protected by the RS code and any detected bit errors have been corrected. Thus, after 58 incoming bits of **Corrected Data** have been received, the **de scrambler** will already be in synch with no need for any special startup/synch loss mechanism.

In order to utilize such a relatively simple self-synchronized de scrambler, the **de scrambler** is preferably located after the **RS decoder**, since it will amplify any decision errors, fed into the de scrambler, by 3X due to its two **XOR** operations. Otherwise, particularly in applications such as EQLN in which the undecoded BER is relatively high, if such a self synchronized de scrambler were placed before the **RS decoder,** its coding gain decoder would be significantly reduced.

### 57/56 Decoder

Finally, the De-**scrambled Data** elements from the De-scrambler are passed into a low latency **57/56** decoder. Unlike the **56/57** encoder, there is no need to wait for all group elements before we can start decode the first group element. The **56/57 overhead** bit is at the beginning of the group and any required 3 or 7 bit control-group index/mask are immediately after that overhead bit, so the decoder already "knows" which type of element to expect next and it can decode it as soon as it arrives.

## Claims

1. System for transmitting and receiving a stream of 8B/10B digital information including 8 bit data words and 4 bit control words, said system comprising:
a group encoder for forming a group of at least six successive said words including a single control overhead bit for indicating whether the group includes any said control words;
an error correcting encoder for adding protection bits to a block of said groups to thereby form a transmission stream of protected blocks of encoded data and control words;
an error correcting decoder responsive to a received stream,of protected blocks of encoded and protected data and control words for identifying the start of each block and recovering the encoded groups of data and control words in said block; and
a group decoder responsive to the control overhead bit in each received block for recovering the individual data and control words from said group.

2. The system of claim 1, further comprising:
a scrambler between the group encoder and the error correcting encoder; and
a descrambler between the error correcting decoder and the group decoder.

3. The system of claim 2, further comprising:
a dc balance adjuster between the scrambler and the error correcting coder; and
a reverse dc balance adjuster between the error correcting circuit and the descrambler circuit.

4. The system of claim of claim 3, wherein the error correcting coder is a Reed Solomon encoder which appends not scrambled and not balance-adjusted protection bits to the scrambled and dc-balance adjusted data and control words.

5. The system of claim 4, wherein the dc balance adjuster is responsive to any disparity changes previously introduced into the transmission stream by the appended protection bits.

6. The system of claim 3, wherein each of said blocks includes 4 groups of six words and 2 groups of seven words.

7. The system of claim 6, wherein each protected block includes at least two bits of side channel information in addition to the 8-bit data words and the 4-bit control words.
